# EUROPEAN PATENT APPLICATION

(11) **EP 4 432 366 A1**
(43) Date of publication of application: **18.09.2024**
(21) Application number: 23191261.9
(22) Date of filing: 14.08.2023
(51) Int. Cl.: H01L 29/417, H01L 29/78, H01L 29/10

(54) **SEMICONDUCTOR DEVICE**

(30) Priority: 14.03.2023 JP 2023039958
(71) Applicant: KABUSHIKI KAISHA TOSHIBA, Minato-ku Tokyo 105-0023 (JP); Toshiba Electronic Devices & Storage Corporation, Tokyo 105-0023 (JP)
(72) Inventor: TOMITA, Kouta, Minato-ku, Tokyo (JP); NISHIWAKI, Tatsuya, Minato-ku, Tokyo (JP)
(74) Representative: Kramer Barske Schmidtchen Patentanwälte PartG mbB

(57) **Abstract**

A semiconductor device according to one embodiment includes: a first electrode; a first semiconductor region of a first conductivity type disposed above the first electrode; an insulating film disposed in the first semiconductor region; a second electrode disposed in the insulating film; a second semiconductor region of a second conductivity type adjacent to the second electrode via the insulating film; a third semiconductor region of the first conductivity type disposed on the second semiconductor region; and a third electrode that is in contact with the first semiconductor region to form a Schottky junction on a first side surface, is in contact with the second semiconductor region and the third semiconductor region on a second side surface opposite to the first side surface, includes a contact portion having a bottom surface located above a bottom surface of the second semiconductor region, and is electrically coupled to the contact portion.

## Description

### CROSS-REFERENCE TO RELATED APPLICATIONS

This application is based upon and claims the benefit of priority from the prior Japanese Patent Application No. 2023-039958, filed on March 14, 2023; the entire contents of which are incorporated herein by reference.

### FIELD

Embodiments described herein relate generally to a semiconductor device.

### BACKGROUND

In a metal oxide semiconductor field effect transistor (MOSFET), a PN junction diode (parasitic diode) is generated between a source and a drain. In order to reduce a loss (recovery loss) in a reverse recovery operation of the parasitic diode, a semiconductor device is known in which a Schottky barrier diode (SBD) having a lower forward voltage than a general PN junction diode is provided separately from the MOSFET.

However, in the above-described semiconductor device, since the Schottky barrier diode is provided in a region different from the MOSFET, a region operating as the MOSFET is reduced, and an on-resistance is increased.

### BRIEF DESCRIPTION OF THE DRAWINGS

FIG. 1A is a cross-sectional view of a semiconductor device according to one embodiment;
FIG. 1B is an enlarged view of a region between semiconductor elements of the semiconductor device according to the embodiment;
FIG. 2 is a cross-sectional view of a semiconductor device according to a modification of the embodiment;
FIG. 3A is a cross-sectional view for explaining an example of a process of a method for manufacturing the semiconductor device according to the embodiment;
FIG. 3B is a cross-sectional view for explaining an example of the process of the method for manufacturing the semiconductor device according to the embodiment, following FIG. 3A;
FIG. 3C is a cross-sectional view for explaining an example of the process of the method for manufacturing the semiconductor device according to the embodiment, following FIG. 3B;
FIG. 3D is a cross-sectional view for explaining an example of the process of the method for manufacturing the semiconductor device according to the embodiment, following FIG. 3C; and
FIG. 3E is a cross-sectional view for explaining an example of a process of the method for manufacturing a semiconductor device according to the modification of the embodiment.

### DETAILED DESCRIPTION

A semiconductor device according to an embodiment includes: a first electrode; a first semiconductor region of a first conductivity type disposed above the first electrode; an insulating film disposed in the first semiconductor region; a second electrode disposed in the insulating film; a second semiconductor region of a second conductivity type adjacent to the second electrode via the insulating film; a third semiconductor region of the first conductivity type disposed on the second semiconductor region; and a third electrode including a contact portion and electrically coupled to the contact portion. The contact portion forms a Schottky junction in contact with the first semiconductor region on a first side surface, is in contact with the second semiconductor region and the third semiconductor region on a second side surface opposite to the first side surface, and has a bottom surface located above a bottom surface of the second semiconductor region.

Embodiments will now be explained with reference to the accompanying drawings. The embodiments do not limit the present invention. The drawings are schematic or conceptual, and a ratio between portions and the like are not necessarily the same as actual ones. In the specification and the drawings, elements similar to those described above regarding the previously described drawings are denoted by the same reference numerals, and detailed description thereof is appropriately omitted.

For convenience of description, an XYZ orthogonal coordinate system is adopted as illustrated in the drawings. A Z-axis direction is a stacking direction (thickness direction) of a semiconductor device. In the Z-axis direction, a source electrode side is also referred to as "above", and a drain electrode side is also referred to as "below". However, this expression is for convenience and independent of a direction of gravity.

In the following description, notations of n⁺, n, and n⁻, and p⁺, p, and p⁻ may be used to represent a relative level of impurity concentration in each conductivity type. That is, n⁺ indicates that an n-type impurity concentration is relatively higher than n, and n⁻ indicates that the n-type impurity concentration is relatively lower than n. In addition, p⁺ indicates that a p-type impurity concentration is relatively higher than p, and p⁻ indicates that the p-type impurity concentration is relatively lower than p. The n-type, n⁺-type, and n⁻-type are examples of the first conductivity type in the claims. The p-type, p⁺-type, and p⁻-type are examples of the second conductivity type in the claims. In the following description, the n-type and the p-type may be reversed. That is, the first conductivity type may be the p-type.

### (One Embodiment)

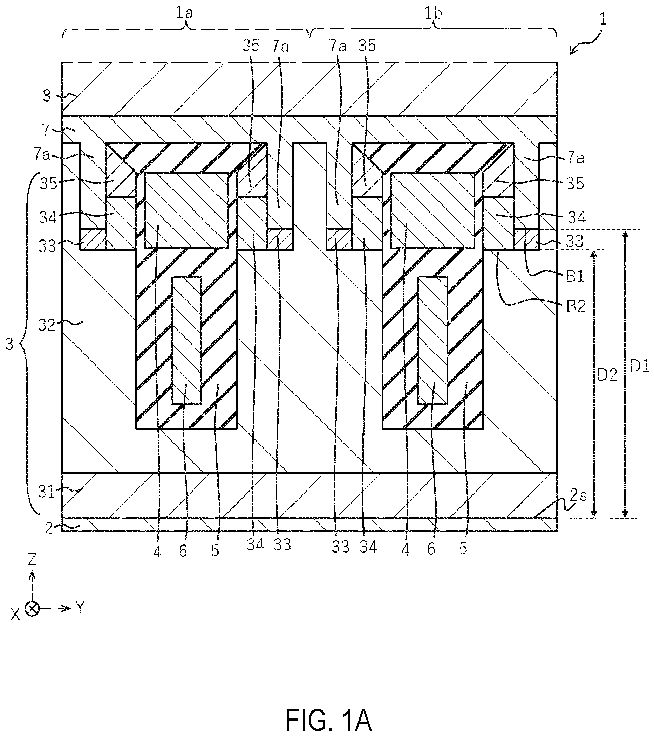

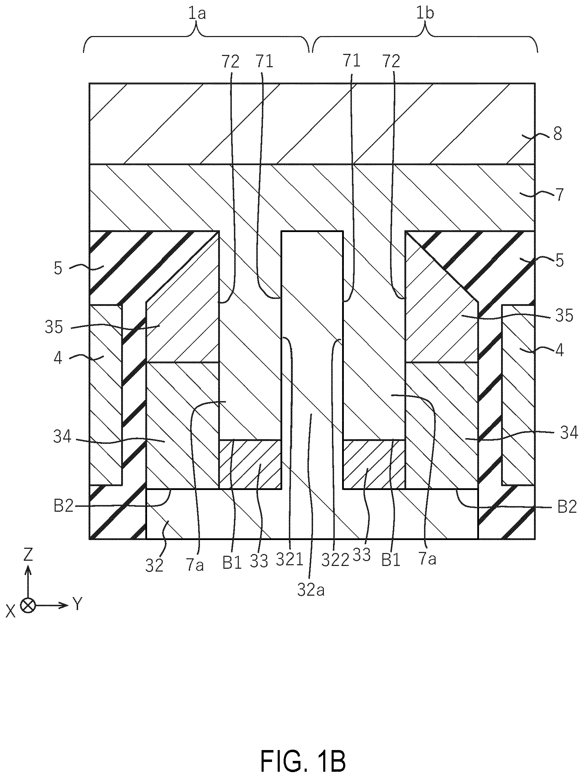

A semiconductor device 1 according to an embodiment will be described with reference to FIGS. 1A and 1B. In the present embodiment, the semiconductor device 1 includes one or a plurality of vertical MOSFETs as semiconductor elements.

As illustrated in FIG. 1A, the semiconductor device 1 includes a drain electrode 2, a semiconductor region 3, a gate electrode 4, a gate insulating film 5, a field plate electrode (FP electrode) 6, a metal 7, and a source electrode 8.

The drain electrode 2 is an electrode that functions as a drain electrode of a MOSFET. The drain electrode 2 is disposed below the semiconductor region 3. The drain electrode 2 is electrically coupled to a drain region 31 included in the semiconductor region 3. The drain electrode 2 is an example of a first electrode in the claims. The drain electrode 2 is made of a metal such as titanium (Ti), nickel (Ni), or silver (Ag).

The semiconductor region 3 is disposed on the drain electrode 2. The semiconductor region 3 includes, for example, a drain region 31, a drift region 32, a contact region 33, a base region 34, and a source region 35.

The drain region 31 is a semiconductor region that functions as a drain of the MOSFET. The drain region 31 is disposed on the drain electrode 2 and is electrically coupled to the drain electrode 2. The drain region 31 is located between the drain electrode 2 and the drift region 32. The drain region 31 is, for example, an n⁺-type semiconductor region.

The drift region 32 is a semiconductor region that functions as a drift region of the MOSFET. The drift region 32 is disposed above the drain electrode 2 and on the drain region 31. The drift region 32 is, for example, an n⁻-type semiconductor region. As illustrated in FIG. 1B, the drift region 32 has a protrusion 32a extending in the Z-axis direction. The drift region 32 is an example of a first semiconductor region in the claims.

The contact region 33 is disposed to form an ohmic junction with the metal 7. In the present embodiment, the contact region 33 is disposed between a bottom surface B1 of a trench contact portion 7a and the base region 34 in the Z-axis direction. The contact region 33 only needs to be in contact with the trench contact portion 7a and the base region 34, and may be disposed, for example, between a side surface of the trench contact portion 7a and the base region 34. The contact region 33 is, for example, a p⁺-type semiconductor region. The contact region 33 is an example of a fourth semiconductor region in the claims. The contact region 33 has a function of suppressing element breakdown due to parasitic transistors formed in the drift region 32, the base region 34, and the source region 35 by preventing generation of a potential difference between the base region 34 and the source electrode 8 (trench contact portion 7a) when a reverse voltage is applied to the MOSFET.

The base region 34 is a semiconductor region that functions as a base of the MOSFET. The base region 34 is adjacent to the gate electrode 4 via the gate insulating film 5. The base region 34 is disposed between a part of the drift region 32 and the gate insulating film 5 in the Y-axis direction orthogonal to the Z-axis direction. The base region 34 is disposed between the trench contact portion 7a and the contact region 33 and the gate insulating film 5 in the Y-axis direction. When a voltage is applied to the gate electrode 4, the base region 34 forms a channel and allows carriers to flow between the drain region 31 and the source region 35. The base region 34 is, for example, a p-type semiconductor region. The base region 34 is an example of a second semiconductor region in the claims.

The source region 35 is a semiconductor region that functions as a source of the MOSFET. The source region 35 is disposed on the base region 34. In the present embodiment, the source region 35 is disposed between the gate insulating film 5 and the trench contact portion 7a in the Y-axis direction. The source region 35 is, for example, an n⁺-type semiconductor region. The source region 35 is an example of a third semiconductor region in the claims.

The semiconductor region 3 may be an epitaxial layer, a semiconductor substrate, or a semiconductor substrate and an epitaxial layer disposed on the semiconductor substrate. In the present embodiment, the semiconductor region 3 is made of, for example, silicon (Si) including impurities. In this case, for example, arsenic (As), phosphorus (P), or antimony (Sb) is used as the n-type impurity. As the p-type impurity, for example, boron (B) is used. The material of the semiconductor region 3 is not limited to silicon, and the semiconductor region 3 may be made of, for example, silicon carbide (SiC). Each of the above-described semiconductor regions included in the semiconductor region 3 is provided extending in the X-axis direction orthogonal to each of the Y-axis direction and the Z-axis direction.

The gate electrode 4 is an electrode that functions as a gate electrode of the MOSFET. The gate electrode 4 is disposed in the gate insulating film 5. The gate electrode 4 is disposed so as to be adjacent to (face) the base region 34 and the source region 35 via the gate insulating film 5 in the Y-axis direction. The gate electrode 4 is provided extending in the X-axis direction. The gate electrode 4 is made of, for example, polysilicon or the like. The gate electrode 4 is an example of a second electrode in the claims.

The gate insulating film 5 is disposed in the drift region 32 and electrically insulates the gate electrode 4 from the semiconductor region 3 and the metal 7. The gate insulating film 5 electrically insulates the FP electrode 6 from the semiconductor region 3. The gate insulating film 5 is made of an insulating material such as silicon oxide or silicon nitride. The gate insulating film 5 is an example of an insulating film in the claims.

The FP electrode 6 is disposed below the gate electrode 4 in the gate insulating film 5, and is electrically coupled to the source electrode 8. The FP electrode 6 is provided extending in the X-axis direction. The FP electrode 6 is disposed to alleviate concentration of a reverse electric field between the gate electrode 4 and the drain electrode 2 and increase a breakdown voltage of the MOSFET. The FP electrode 6 is made of, for example, polysilicon or the like. The FP electrode 6 is an example of a fourth electrode in the claims.

The metal 7 is provided on the semiconductor region 3 and the gate insulating film 5. The metal 7 partially includes a trench contact portion 7a that extends in the direction toward the drift region 32 (Z-axis negative direction). The trench contact portion 7a is in contact with the contact region 33, the base region 34, and the source region 35 in the Y-axis direction. A Schottky junction is formed between the trench contact portion 7a and the drift region 32 (protrusion 32a). The metal 7 may function as a barrier metal used to prevent a reaction between a metal material of the source electrode 8 and a semiconductor material of the semiconductor region 3. The metal 7 (particularly, the trench contact portion 7a) includes, for example, titanium (Ti), cobalt (Co), nickel (Ni), platinum (Pt), tungsten (W), or the like. In the metal 7, the trench contact portion 7a and the other portions may be made of different materials. The metal 7 is an example of a third electrode in the claims. The trench contact portion 7a is an example of a contact portion in the claims.

As illustrated in FIG. 1A, a bottom surface (lower end) B1 of the trench contact portion 7a is located above a bottom surface (lower end) B2 of the base region 34. That is, a distance D1 from an upper main surface 2s of the drain electrode 2 to the bottom surface B1 is larger than a distance D2 from the main surface 2s to the bottom surface B2.

The source electrode 8 is an electrode that functions as a source electrode of the MOSFET. The source electrode 8 is provided on the metal 7 and is electrically coupled to the metal 7 (trench contact portion 7a). The source electrode 8 is made of, for example, copper, aluminum, or the like.

The configuration of the trench contact portion 7a and the periphery thereof will be described in more detail with reference to FIG. 1B. FIG. 1B is an enlarged view of a vicinity of a boundary between a first region 1a and a second region 1b adjacent in the Y-axis direction included in the semiconductor device 1. Both the first region 1a and the second region 1b include a MOSFET operation region. As illustrated in FIG. 1B, the trench contact portion 7a has a side surface 71 and a side surface 72 opposite to the side surface 71. The trench contact portion 7a is in contact with the drift region 32 (specifically, the protrusion 32a included in the drift region 32) on the side surface 71 to form a Schottky junction. As a result, a recovery loss of the parasitic diode formed by the base region 34 (p-type) and the drift region 32 (n-type) can be reduced. The trench contact portion 7a is in contact with the base region 34 and the source region 35 on the side surface 72.

As illustrated in FIG. 1B, the trench contact portion 7a may be in contact with the drift region 32 in the entire region of the side surface 71 to form the Schottky junction. As a result, since an area of the Schottky junction can be increased, the recovery loss of the parasitic diode can be more effectively reduced.

As illustrated in FIG. 1B, the protrusion 32a has a side surface 321 and a side surface 322 opposite to the side surface 321. The side surface 321 is in contact with the side surface 71 of the trench contact portion 7a included in the first region 1a to form the Schottky junction, and the side surface 322 is in contact with the side surface 71 of the trench contact portion 7a (that is, another trench contact portion) included in the second region 1b to form the Schottky junction. In other words, the protrusion 32a is sandwiched between the two trench contact portions 7a provided in each of the two adjacent first and second regions 1a and 1b, and forms the Schottky junction with each trench contact portion 7a. An impurity concentration of the protrusion 32a may be lower than an impurity concentration of the drift region 32 other than the protrusion 32a.

As described above, in the present embodiment, the trench contact portion 7a is in contact with the drift region 32 (protrusion 32a) on the side surface 71 to form the Schottky junction, and is in contact with the base region 34 and the source region 35 on the side surface 72. As a result, a Schottky barrier diode can be provided in a narrow region between the MOSFET operation regions. Therefore, a wide area of the MOSFET operation region can be secured. Therefore, according to the present embodiment, it is possible to reduce the recovery loss of the parasitic diode without increasing an on-resistance. Furthermore, the semiconductor device can be downsized.

Furthermore, in the present embodiment, as described above, the bottom surface (lower end) B1 of the trench contact portion 7a is located above the bottom surface (lower end) B2 of the base region 34 (that is, the bottom surface B1 is at a location shallower than the bottom surface B2). As a result, a depletion layer spreading from the trench contact portion 7a to the lower portion of the drift region 32 is suppressed as compared with a case where the bottom surface B1 is located deeper than the bottom surface B2. Therefore, it is not necessary to thicken the drift region 32, and an increase in the on-resistance can be prevented.

Specifically, in a case where the trench contact portion 7a is provided deep (the bottom surface B1 is deepened), it is necessary to make the drift region 32 thick since the depletion layer generated below the trench contact portion 7a extends to the lower portion of the drift region 32. However, increasing the thickness of the drift region 32 increases the on-resistance. On the other hand, in the present embodiment, since the bottom surface B1 is located above the bottom surface B2, the depletion layer generated below the trench contact portion 7a does not extend to the lower portion of the drift region 32. Therefore, it is not necessary to thicken the drift region 32, and an increase in the on-resistance can be prevented. Since the bottom surface B1 is shallow, there is a possibility that electric field concentration generated at the bottom portion of the gate electrode 4 is not sufficiently alleviated. However, when the electric field concentration at the bottom portion of the gate electrode 4 is not so large (for example, when the semiconductor region 3 is made of silicon), there is no particular problem.

In a case where the trench contact portion 7a is provided deep, the electric field generated below the trench contact portion 7a extends to the lower portion of the drift region 32, so that an avalanche withstand capability decreases. In order to prevent this, it is necessary to make the drift region 32 thick. On the other hand, in the present embodiment, since the bottom surface B1 is located above the bottom surface B2, the electric field generated below the trench contact portion 7a does not extend to the lower portion of the drift region 32. Therefore, it is possible to reduce the recovery loss of the parasitic diode without increasing the thickness of the drift region 32 in order to prevent the decrease in the avalanche withstand capability.

As described above, according to the present embodiment, it is possible to reduce the recovery loss of the parasitic diode while keeping the on-resistance of the semiconductor element low. It is possible to reduce the recovery loss of the parasitic diode while preventing the decrease in the avalanche withstand capability of the semiconductor element.

In the semiconductor device 1, the field plate electrode 6 and/or the contact region 33 may be omitted.

### (Modification)

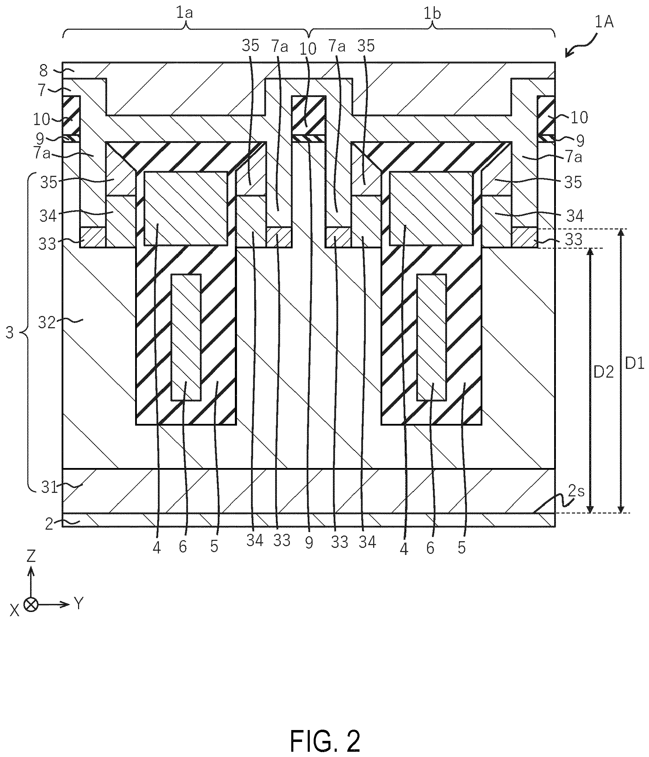

Here, the semiconductor device 1 according to a modification of the present embodiment will be described with reference to FIG. 2.

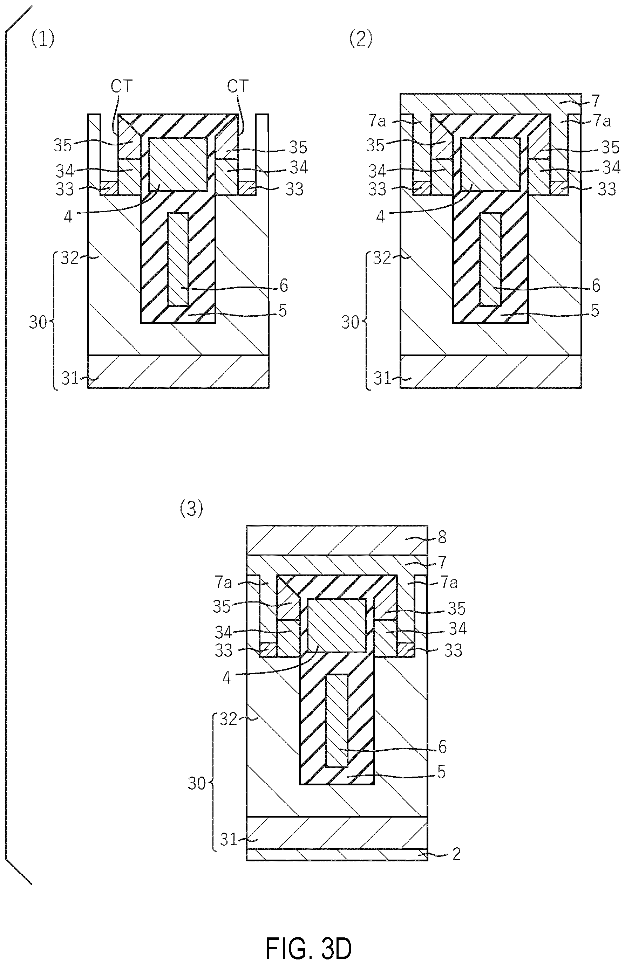

FIG. 2 is a cross-sectional view of a semiconductor device 1A according to the present modification. As illustrated in FIG. 2, the semiconductor device 1A according to the present modification includes an insulating film 9 and an insulating film 10 disposed on a protrusion 32a. According to the present modification, it is possible to obtain an effect equivalent to that of the above-described embodiment. In a method for manufacturing a semiconductor device to be described later, an etching process of removing the insulating films 9 and 10 (see (1) of FIG. 3D) can be omitted.

### <Method for Manufacturing Semiconductor Device>

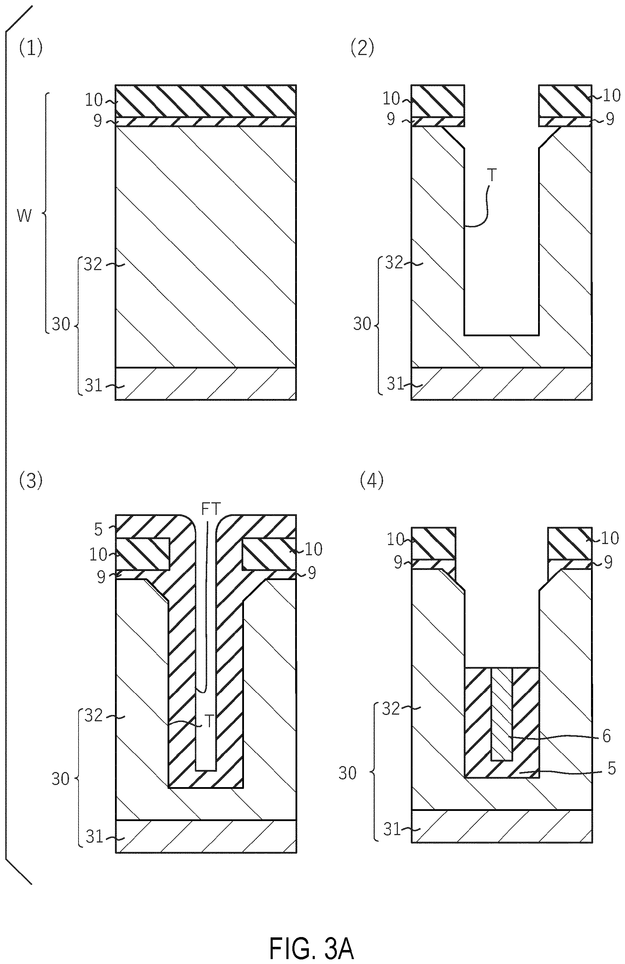

An example of a method for manufacturing the semiconductor device 1 described above will be described with reference to FIGS. 3A to 3D. Although the semiconductor device 1 includes one or a plurality of semiconductor elements, only one semiconductor element is illustrated in FIGS. 3A to 3D in order to avoid complexity.

First, as illustrated in (1) of FIG. 3A, a wafer 3A in which the insulating film 9 and the insulating film 10 are disposed on an upper surface of a semiconductor layer 30 is prepared. The semiconductor layer 30 includes the drain region 31 and the drift region 32. The insulating film 9 is made of, for example, silicon oxide. The insulating film 10 is made of, for example, silicon nitride. The insulating film 9 is disposed on the semiconductor layer 30, and the insulating film 10 is disposed on the insulating film 9.

Next, as illustrated in (2) of FIG. 3A, for example, a trench T is formed in the semiconductor layer 30 (drift region 32) by combining reactive ion etching (RIE) or the like and wet etching. Specifically, first, a resist mask (not illustrated) is formed on the insulating film 10, and the insulating films 9 and 10 and a part of the drift region 32 are removed by the RIE to form a trench. Thereafter, the trench is expanded by wet etching to form the trench T.

Next, as illustrated in (3) of FIG. 3A, an insulating material is deposited on an inner surface (bottom surface and side surface) of the trench T by physical vapor deposition (PVD), chemical vapor deposition (CVD), or the like to form an insulating film 5. The insulating material is, for example, silicon oxide. An FP trench FT is formed by the present process. In the present embodiment, since the insulating film 9 and the insulating film 5 are made of the same material, the insulating film 9 is integrated with the insulating film 5.

Next, a conductive material such as polysilicon is deposited on the insulating film 5 so as to fill the FP trench FT. Thereafter, a part of the deposited polysilicon is removed by combining chemical mechanical polishing (CMP), chemical dry etching (CDE), wet etching, and the like. As a result, as illustrated in (4) of FIG. 3A, an FP electrode 6 is formed.

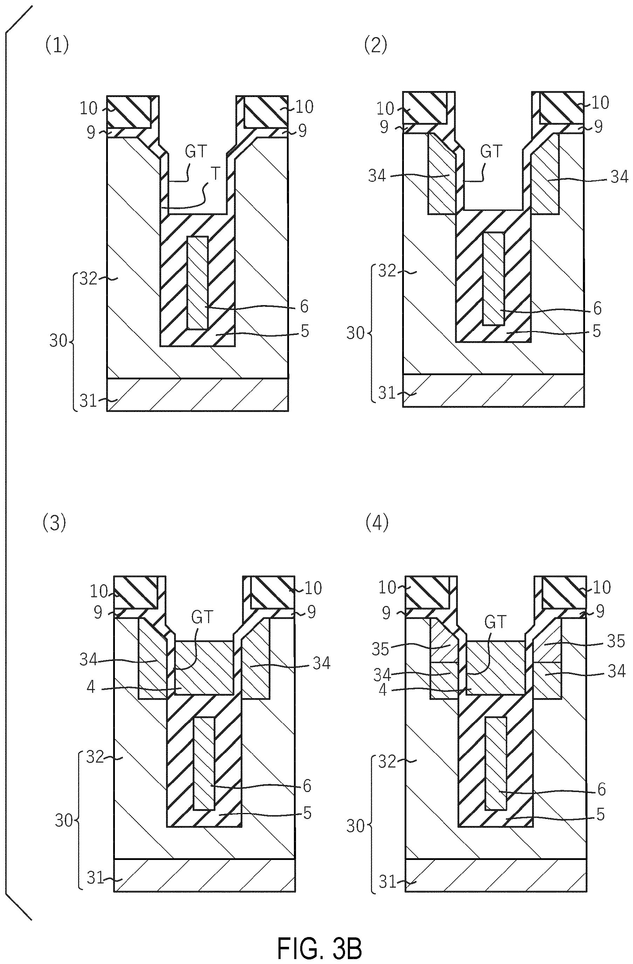

Next, as illustrated in (1) of FIG. 3B, by depositing an insulating material such as silicon oxide in the trench T by physical vapor deposition (PVD), chemical vapor deposition (CVD), or the like, the FP electrode 6 is buried in the insulating film 5. In the present process, the insulating material is also deposited on the side surface of the trench T to form a gate trench GT.

Next, for example, p-type impurity ions are ion-implanted into the drift region 32 via the side surface of the gate trench GT. Thereafter, as illustrated in (2) of FIG. 3B, impurities are activated and diffused by heat treatment to form a base region 34 in the drift region 32 so as to surround the gate trench GT.

Next, a conductive material such as polysilicon is deposited so as to fill the gate trench GT. Thereafter, CMP, CDE, and the like are combined to remove a part of the deposited polysilicon, thereby forming a gate electrode 4 as illustrated in (3) of FIG. 3B.

Next, for example, n-type impurity ions are ion-implanted into the upper portion of the base region 34 via the gate trench GT. Thereafter, as illustrated in (4) of FIG. 3B, the impurities are activated by heat treatment to form a source region 35. The source region 35 and the base region 34 may be formed simultaneously. That is, the p-type impurity ions and the n-type impurity ions may be ion-implanted into the drift region 32, and then heat treatment may be performed simultaneously to form the source region 35 and the base region 34.

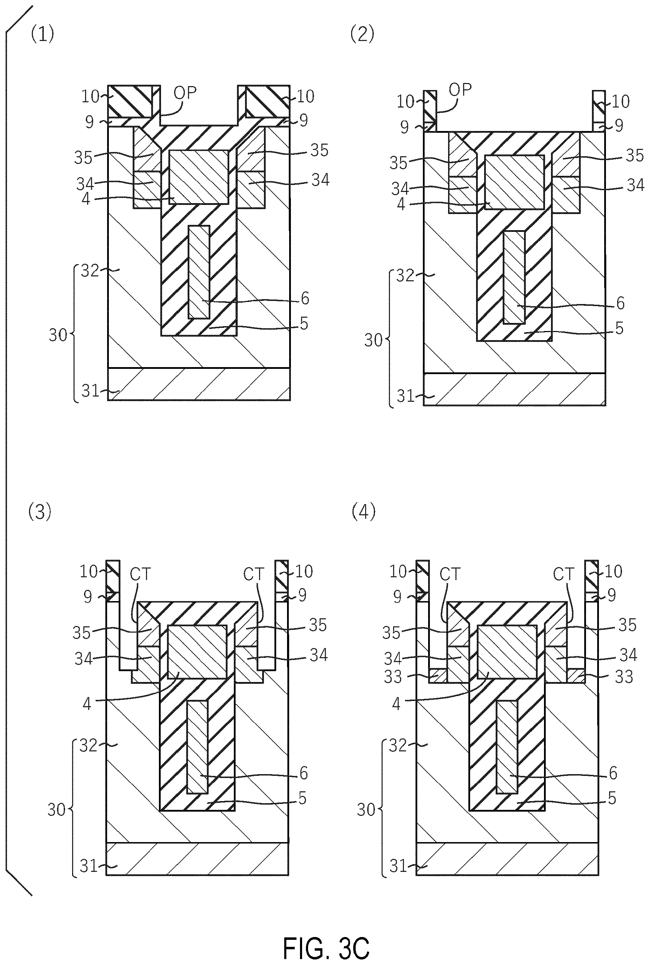

Next, the gate electrode 4 is buried in the insulating film 5 by depositing an insulating material such as silicon oxide on the gate electrode 4 by physical vapor deposition (PVD), chemical vapor deposition (CVD), or the like. Thereafter, as illustrated in (1) of FIG. 3C, a part of the insulating film 5 is removed by the RIE or the like, and an opening OP is formed above the electrode 4.

Next, as illustrated in (2) of FIG. 3C, a part of the insulating film 5 and the insulating film 10 is removed by wet etching to widen the opening OP. Specifically, the opening OP is widened until the drift region 32 is exposed on the bottom surface of the opening OP. A width of the trench contact portion 7a is determined by a width of the expanded opening OP. At the same time, a final shape of the insulating film 5 is determined.

Next, as illustrated in (3) of FIG. 3C, a part of the drift region 32 is removed by the RIE or the like by using the insulating film 10 and the insulating film 5 as masks (etching stoppers). Thus, the contact trench CT is formed on both sides of the insulating film 5. Specifically, the contact trench CT is formed to have a depth shallower than that of the base region 34. A final range of the source region 35 is determined by forming the contact trench CT in the present process.

Next, for example, the p-type impurity ions are ion-implanted into a bottom surface of the contact trench CT. Thereafter, as illustrated in (4) of FIG. 3C, the impurities are activated by heat treatment to form a contact region 33. A final range of the base region 34 is determined by forming the contact region 33 in the present process.

Next, as illustrated in (1) of FIG. 3D, the insulating film 9 and the insulating film 10 are removed by, for example, dry etching or wet etching.

Next, as illustrated in (2) of FIG. 3D, the metal 7 is formed by depositing a first metal material so as to fill the contact trench CT. For the deposition of the first metal material, for example, a vapor deposition method or a sputtering method is used. The first metal material includes, for example, titanium, cobalt, nickel, platinum, tungsten, or the like. The first metal material filled in the contact trench CT becomes the trench contact portion 7a.

Thereafter, as illustrated in (3) of FIG. 3D, a second metal material is deposited on the metal 7 to form a source electrode 8. For the deposition of the second metal material, for example, a vapor deposition method or a sputtering method is used. The second metal material includes, for example, copper, aluminum, or the like. A third metal material is deposited on a lower surface of the drain region 31 to form a drain electrode 2. For the deposition of the third metal material, for example, a vapor deposition method or a sputtering method is used. The third metal material includes, for example, titanium, nickel, silver, and the like.

Through the above processes, the semiconductor device 1 according to the embodiment is manufactured. The above description is merely an example of a method for manufacturing the semiconductor device 1, and the semiconductor device 1 can be manufactured by other methods. For example, in the process of filling the contact trench CT with the metal material, the first metal material may be deposited only in each contact trench CT. In this case, the source electrode 8 is formed on the insulating film 5.

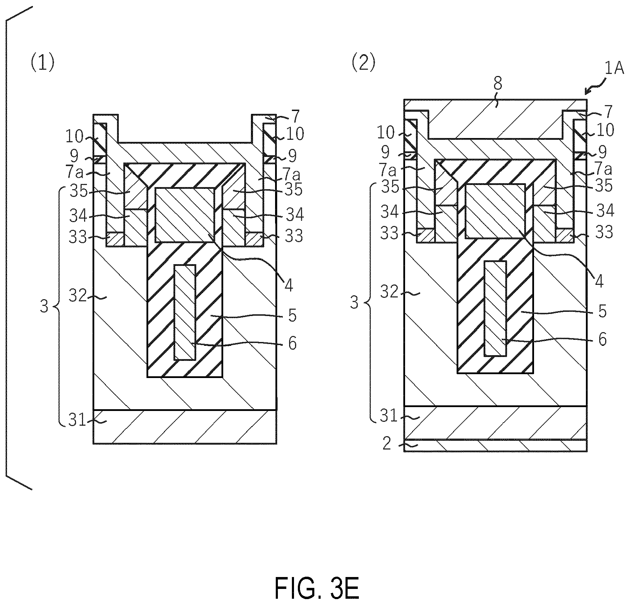

As described above, in the manufacturing of the semiconductor device 1A according to the modification of the embodiment, the processes can be partially omitted. Here, the method for manufacturing the semiconductor device 1A according to the modification of the embodiment will be described with reference to FIG. 3E.

After the process illustrated in (4) of FIG. 3C, as illustrated in (1) of FIG. 3E, the first metal material is stacked to form the metal 7 while the insulating film 9 and the insulating film 10 are left without being removed. Thereafter, as illustrated in (2) of FIG. 3E, the second metal material is stacked on the metal 7 to form the source electrode 8. The second metal material is deposited on the lower surface of the semiconductor region 3 (drain region 31) to form the drain electrode 2. Through the above processes, the semiconductor device 1A according to the modification of the embodiment is manufactured.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A semiconductor device comprising:
a first electrode (2);
a first semiconductor region (32) of a first conductivity type disposed above the first electrode (2);
an insulating film (5) disposed in the first semiconductor region;
a second electrode (4) disposed in the insulating film;
a second semiconductor region (34) of a second conductivity type adjacent to the second electrode (4) via the insulating film (5);
a third semiconductor region (35) of the first conductivity type disposed on the second semiconductor region (34); and
a third electrode (7) electrically coupled to a contact portion (7a), the contact portion (7a) being in contact with the first semiconductor region (32) to form a Schottky junction on a first side surface, being in contact with the second semiconductor region (34) and the third semiconductor region (35) on a second side surface opposite to the first side surface, and having a bottom surface located above a bottom surface of the second semiconductor region (34).

2. The semiconductor device according to claim 1, wherein
the first semiconductor region (32) has a protrusion (32a) having a third side surface in contact with the first side surface of the contact portion, and
the protrusion (32a) is in contact with another contact portion to form a Schottky junction on a fourth side surface opposite to the third side surface.

3. The semiconductor device according to claim 1 or 2, wherein
the contact portion is in contact with the first semiconductor region in an entire region of the first side surface to form a Schottky junction.

4. The semiconductor device according to any one of claims 1 to 3, further comprising:
a fourth semiconductor region (33) of the second conductivity type that is in contact with the contact portion (7a) and the second semiconductor region (34) and has a higher impurity concentration than the second semiconductor region.

5. The semiconductor device according to claim 4, wherein
the fourth semiconductor region (33) is disposed between a bottom surface of the contact portion (7a) and the first semiconductor region (32).

6. The semiconductor device according to any one of claims 1 to 5, further comprising:
a fourth electrode (6) disposed below the second electrode (4) in the first insulating film (5) and electrically coupled to the third electrode (7).

7. The semiconductor device according to any one of claims 1 to 6, wherein
the first semiconductor region has a protrusion (32a) in contact with the first side surface of the contact portion (7a), and
the semiconductor device further comprises an insulating film (9, 10) disposed on the protrusion.

8. The semiconductor device according to any one of claims 1 to 7, wherein
the first semiconductor region, the second semiconductor region, and the third semiconductor region are made of silicon including impurities.

9. The semiconductor device according to claim 8, wherein
the contact portion includes titanium, cobalt, nickel, platinum, or tungsten.

10. The semiconductor device according to any one of claims 1 to 9, wherein
the insulating film is made of silicon oxide or silicon nitride.

11. The semiconductor device according to any one of claims 1 to 10, wherein
the first conductivity type is n-type, and the second conductivity type is p-type.
